# DEMANDE DE BREVET EUROPEEN

(11) **EP 0 709 685 A1**
(43) Date de publication de la demande: **01.05.1996**
(21) Numéro de dépôt: 95402351.1
(22) Date de dépôt: 23.10.1995
(51) Int. Cl.: G01R 1/04

(54) **Appareil de mesure électrique comportant un compartiment de pile à accès protégé**

(30) Priorité: 26.10.1994 DE 4438239
(71) Demandeur: GENERAL ELEKTRONIK GmbH bei MAGDEBURG, D-39167 Hohendodeleben bei Magdeburg (DE)
(72) Inventeur: Meiler, Ernst, D-90556 Cadolzburg (DE); Schnepf, Norbert, D-90547 Stein (DE)
(74) Mandataire: Kohn, Philippe

(57) **Abrégé**

L'invention concerne un appareil de mesure électrique (10) disposé dans un boîtier d'appareil (11) présentant, sur une de ses faces (16), des fiches femelles (12) de connexion électrique pouvant recevoir chacune une fiche mâle (13) reliée à un cordon de mesure, l'appareil de mesure (10) comportant une source de tension (34) constituée par au moins un générateur électrochimique et logée dans un compartiment (23,31) qui est fermé par un capot (14) amovible qui présente des trous (39), qui, en position normale, sont alignés avec les fiches femelles (12) de manière à permettre le passage des fiches mâles (13), et dans lequel le capot (14) est mobile en translation par rapport au boîtier d'appareil (11) de manière à permettre l'accès à la source de tension (34), caractérisé en ce que le capot est constitué par un boîtier adaptateur (14) amovible monté sur le boîtier de l'appareil (11) et coulissant sur ce dernier selon une direction (A) orthogonale aux axes des fiches femelles (12), les trous (39) du boîtier adaptateur (14) étant aménagés dans une zone de paroi (28) de ce dernier coulissant devant les fiches femelles (12).

## Description

La présente invention concerne un appareil de mesure électrique comportant un compartiment de pile à accès protégé.

L'invention concerne plus particulièrement un appareil disposé dans un boîtier d'appareil présentant, sur une de ses faces, des fiches femelles de connexion électrique pouvant recevoir chacune une fiche mâle reliée à un cordon de mesure, l'appareil de mesure comportant une source de tension constituée par au moins un générateur électrochimique et logée dans un compartiment qui est fermé par un capot amovible qui présente des trous qui, en position normale, sont alignés avec les fiches femelles de manière à permettre le passage des fiches mâles, et du type dans lequel le capot est mobile en translation par rapport au boîtier d'appareil de manière à permettre l'accès à la source de tension.

Dans de nombreux appareils de mesure alimentés par au moins une pile interne, le changement de la pile constituant la source de tension interne est effectué en ouvrant le boîtier. Cette opération peut donc être réalisée sans que les cordons de mesure ne soient débranchés, ce qui présente un danger de chocs électriques pour l'opérateur.

L'appareil décrit dans le document EP-B1-0.366.507 permet le changement de la pile sans danger. Il comporte un boîtier dans lequel est aménagé un compartiment de pile qui est fermé par un capot qui présente des trous alignés avec les fiches femelles de connexion.

Pour changer la pile, on enlève le capot en le tirant parallèlement à l'axe des fiches femelles. Pour garantir que cette opération ne puisse s'effectuer sans que les cordons de mesure ne soient débranchés, il est prévu un dispositif de verrouillage qui bloque le capot et qui ne peut être retiré que si les fiches mâles ont été retirées au préalable.

Cette procédure de changement de la pile est donc complexe et, du fait qu'elle est réalisée avec une faible périodicité, l'utilisateur l'a généralement oubliée lorsque la pile est à changer et il doit rechercher la notice d'emploi pour la retrouver.

Par ailleurs, il est fréquent que les appareils de mesure du type décrit ci-dessus soient prévus avec des options interchangeables qui sont obtenues au moyen de circuits électroniques optionnels que l'on rajoute à l'appareil. Il est souhaitable que l'opération de mise en place ou de remplacement d'un circuit électronique optionnel s'effectue de manière simple et avec la même sécurité que pour le remplacement de la source de tension.

A cet effet, l'invention a pour objet un appareil de mesure du type précité qui est caractérisé en ce que le capot est constitué par un boîtier adaptateur amovible monté sur le boîtier de l'appareil et coulissant sur ce dernier selon une direction orthogonale aux axes des fiches femelles, les trous du boîtier adaptateur étant aménagés dans une zone de paroi de ce dernier coulissant devant les fiches femelles.

L'accès au compartiment de la source de tension interne est obtenu de manière simple en faisant coulisser le boîtier adaptateur et ceci ne peut être réalisé que si les fiches mâles ont été enlevées, c'est-à-dire seulement si les cordons de mesure ont été débranchés.

Avantageusement, le boîtier adaptateur comporte un compartiment destiné à recevoir un circuit électronique optionnel. Ce dernier comporte un connecteur qui, en position normale, passe à travers une ouverture du boîtier de l'appareil.

Ceci permet la mise en place ou le remplacement d'une option selon la même procédure que pour le changement de la source de tension. De plus, cette procédure étant commune aux deux opérations et, par suite, effectuée plus fréquemment, elle sera plus facilement mémorisée par l'utilisateur.

Selon une autre caractéristique de l'invention, le compartiment de la source de tension est constitué, au moins partiellement, par une cuvette agencée dans le boîtier de l'appareil.

Selon encore une autre caractéristique de l'invention, ce compartiment de la source de tension est constitué, au moins partiellement, par un logement formé dans le boîtier adaptateur.

De cette manière, ce compartiment est totalement séparé des circuits électroniques de base qui sont logés dans le boîtier et qui sont donc mieux protégés contre les contacts et l'environnement extérieur.

Par ailleurs, le branchement de la source de tension et du circuit électronique optionnel avec les circuits électroniques de base s'effectue simultanément et automatiquement lors de la mise place du boîtier adaptateur sur le boîtier de l'appareil.

Selon encore une autre caractéristique de l'invention, la zone de paroi du boîtier adaptateur dans laquelle sont aménagés les trous est constituée par une partie saillante d'une paroi du boîtier adaptateur.

Avantageusement, cette partie saillante s'engage dans un évidement de la face du boîtier de l'appareil portant les fiches femelles et elle est guidée dans cette face.

Ceci facilite l'opération de mise place du boîtier adaptateur sur le boîtier de l'appareil ainsi que son enlèvement.

D'autres caractéristiques et avantages de l'invention ressortiront de la description qui suit d'un mode de réalisation de l'invention, faite en se référant aux dessins annexés dans lesquels :
- la figure 1 représente, en coupe schématique longitudinale, de manière partiellement tronquée, un exemple de réalisation préférée de la présente invention, dans l'état d'un changement de pile;
- la figure 2 est une vue partielle de dessus selon la flèche II de la figure 1; et
- la figure 3 est une vue correspondant à celle de la figure 1, mais dans la position normale correspondant à l'état d'utilisation de l'appareil.

L'exemple de réalisation préférée représenté sur les dessins est un appareil de mesure 10 du type à pince ampèremétrique qui est alimenté par une pile ou un élément électrochimique rechargeable.

Il comporte un boîtier 11 à l'extrémité arrière duquel sont prévues plusieurs fiches femelles ou douilles 12, au nombre de trois dans l'exemple représenté, qui sont destinées au raccordement de cordons de mesure 13. A l'extrémité avant de l'appareil de mesure 10 est fixée une pince de mesure non représentée et un dispositif mécanique permettant l'ouverture de cette pince de mesure.

Les douilles 12 sont prévues sur la face intérieure d'une paroi frontale arrière 16 qui présente plusieurs ouvertures 17 (trois dans l'exemple représenté) qui sont disposées de telle manière qu'elles permettent un accès aux douilles 12 disposées à l'intérieur du boîtier 11 de l'appareil.

Les douilles 12 sont maintenues sans possibilité de rotation à l'intérieur du boîtier 11 de l'appareil au moyen d'un quatre-pans 18. Parallèlement à une paroi extérieure 19 se trouve un élément arrière de paroi interne 20 du boîtier 11 de l'appareil. Cet élément arrière de paroi interne 20 est disposé en retrait par rapport à un élément de paroi interne 21 et forme ainsi un compartiment de réception 22 pour un boîtier adaptateur 14.

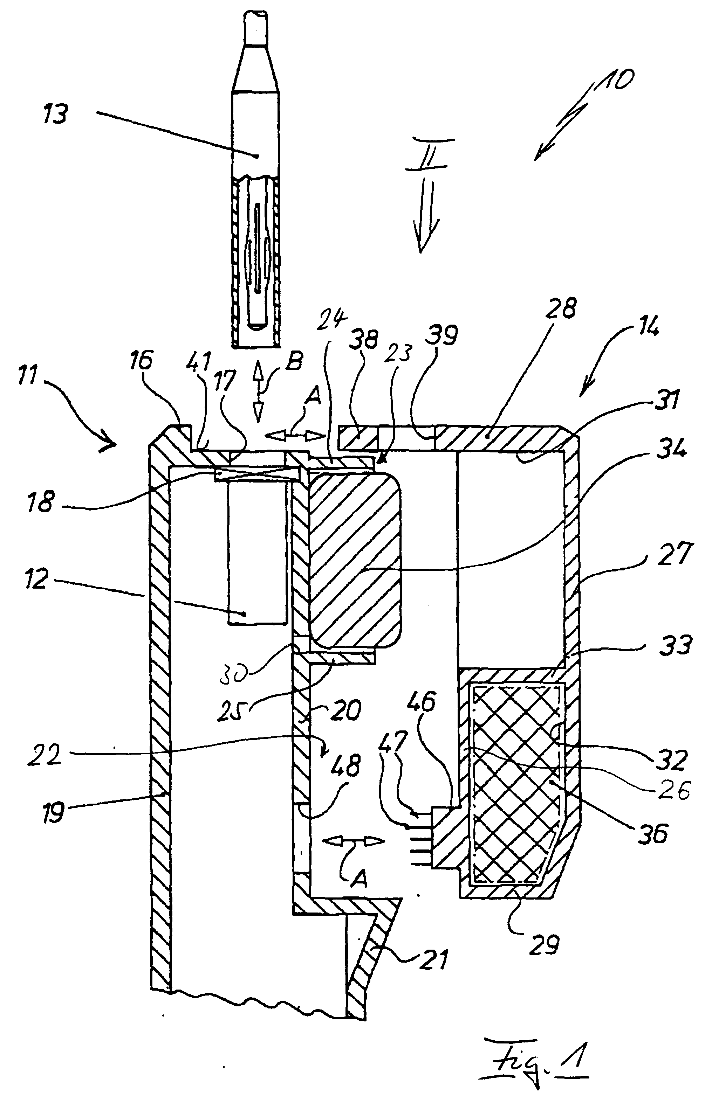

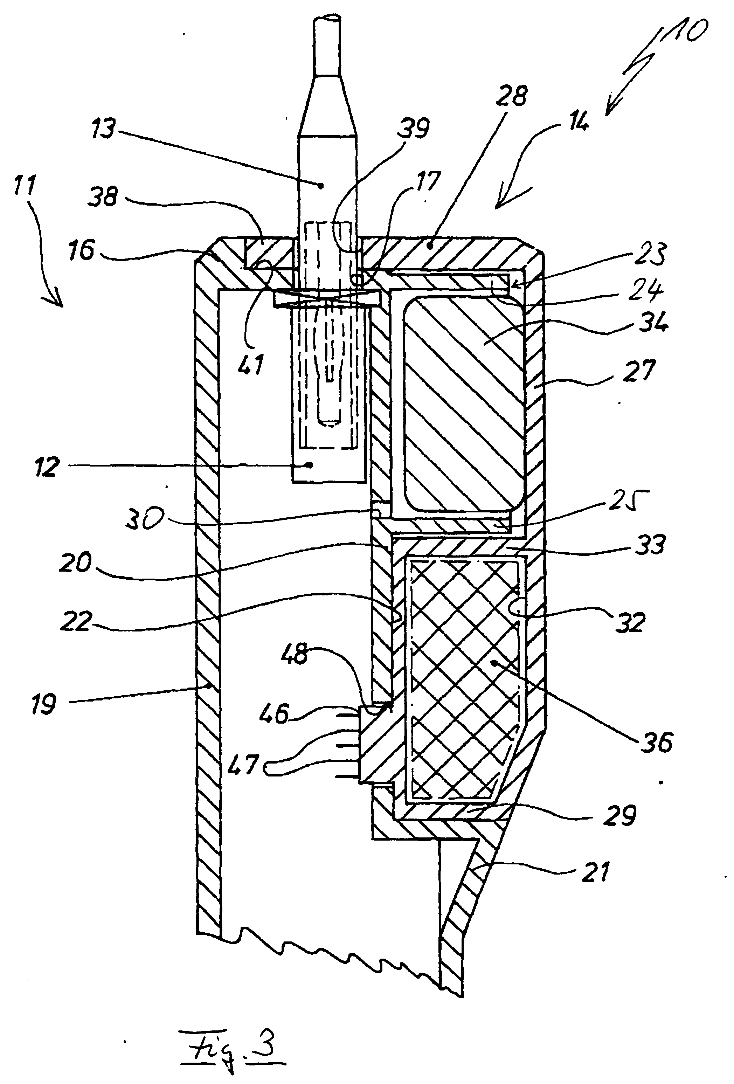

Dans le compartiment de réception 22, en face de la paroi frontale arrière 16, est agencée une cuvette 23 destinée à recevoir une ou plusieurs piles 34. Sur les figures 1 et 3, seules les deux parois longitudinales 24 et 25 et le fond de la cuvette 23 sont visibles. Le fond est formé par une partie de la paroi intermédiaire 20 et un passage 30 y est prévu pour la traversée de conducteurs de liaison.

Le boîtier adaptateur 14 est de forme générale parallélépipédique, c'est-à-dire qu'il comporte une paroi externe 27, une paroi interne 26 qui s'étend essentiellement parallèlement à une zone partielle de la paroi externe 27, une paroi frontale arrière 28, une paroi frontale avant 29 et une paroi intermédiaire 33 qui divise l'espace interne du boîtier adaptateur 14 en deux compartiments 31 et 32.

Le compartiment 31 ouvert vers l'intérieur et qui est disposé du côté de la paroi frontale arrière 28 sert à recevoir la cuvette 23 munie de la ou des piles 34, tandis que le compartiment fermé 32 disposé du côté de la paroi frontale avant 29 sert à recevoir un circuit électronique, tel qu'un circuit électronique optionnel 36.

La paroi frontale arrière 28 est prolongée par une partie saillante 38 un peu plus étroite qui se trouve devant la paroi frontale arrière 16. Cette partie saillante 38 présente plusieurs trous 39 de forme circulaire (trois dans l'exemple représenté).

La partie saillante 38 s'adapte dans un évidement 41 qui est prévu dans la paroi frontale arrière 16 du boîtier 11 de l'appareil. De manière non représentée en détails, les faces latérales étroites 32 de la partie saillante 38 et de la séparation latérale 43 de l'évidement 41 de la paroi frontale arrière 16 sont munies de dispositifs de guidage, par exemple sous la forme de liaison à queue d'aronde ou analogue.

Au voisinage de la paroi frontale avant 29, sur la paroi interne 26, est formé un boîtier 46 de connecteur dont les broches 47 sont reliées à la ou aux piles 34 et/ou au circuit électronique optionnel 36. En face de ce boîtier 46 de connecteur, dans l'élément de paroi interne 21 du boîtier 11 de l'appareil, il est prévu un évidement 48 dans lequel s'engage le boîtier 46 de connecteur.

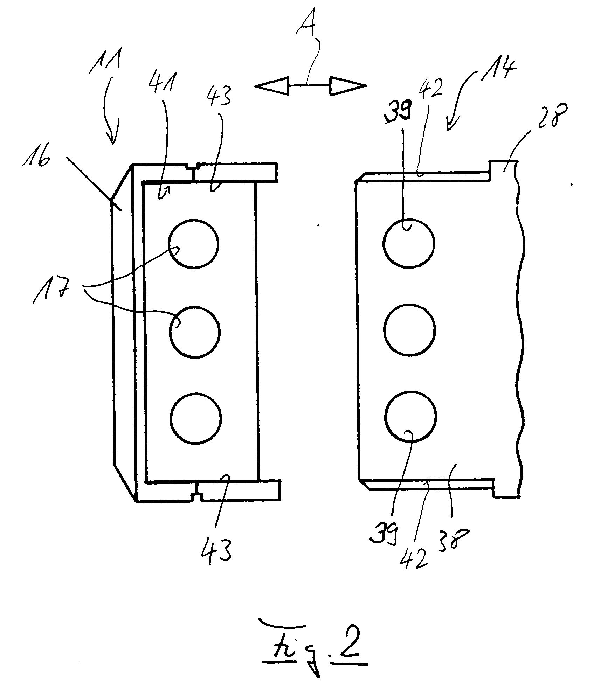

Pour obtenir l'état de fonctionnement de l'appareil de mesure 10, le boîtier adaptateur 14 est mis en place sur le boîtier 11 de l'appareil en le déplaçant dans la direction des flèches A, comme représenté sur les figures 1 et 2.

Lorsque le boîtier adaptateur 14 est installé sur le boîtier 11 de l'appareil comme représenté sur la figure 3, la partie saillante 38 recouvre la paroi frontale arrière 16 du boîtier 11 de l'appareil de telle manière que les trous circulaires 39 aménagés dans le boîtier adaptateur 14 sont en recouvrement avec les ouvertures 17, également circulaires, aménagées dans le boîtier 11 de l'appareil ou sont alignés avec elles.

On peut ensuite introduire les cordons de mesure 13 dans les douilles 12 en traversant les trous circulaires 39 selon la direction de la flèche B. Comme on peut le voir sur la figure 3, lorsque les cordons de mesure 13 sont branchés, c'est-à-dire dans l'état de fonctionnement de l'appareil de mesure 10, il n'est pas possible de retirer le boîtier adaptateur 14 pour un changement de piles.

Le boîtier adaptateur 14 amovible qui ne peut être retiré que lorsque les cordons de mesure 13 sont débranchés et qui fournit alors un accès à la ou les piles 34, peut, en vue d'une modification de l'appareil de mesure 10, être échangé avec un autre boîtier adaptateur qui est équipé d'un circuit électronique optionnel présentant d'autres caractéristiques.

Comme on peut aussi le voir sur la figure 3, dans l'état monté du boîtier adaptateur 14, le boîtier de connecteur 46 comportant les broches 47 est logé dans l'évidement 48 de telle manière que, de manière non représentée, on réalise une liaison électrique entre les composants du circuit électronique optionnel 36 se trouvant dans le boîtier adaptateur 14 et des composants correspondants se trouvant dans le boîtier 11 de l'appareil.

Dans l'exemple de réalisation représenté, on a prévu aussi dans la partie saillante 38, pour chaque cordon de mesure 13, un trou circulaire 39. Il est évident qu'il est aussi possible de remplacer ces trous circulaires 39 par un trou unique allongé pour obtenir le verrouillage forcé intégré décrit plus haut entre le boîtier adaptateur 14 et le boîtier 11 de l'appareil lorsque les cordons de mesure 13 sont branchés.

De manière également non représentée, dans l'état monté du boîtier adaptateur 14 sur le boîtier 11 de l'appareil comme représenté sur la figure 3, on prévoit un accrochage intégré entre les éléments de paroi disposés les uns à côté des autres afin d'obtenir un bon positionnement et un verrouillage du boîtier adaptateur 14 sur le boîtier 11 de l'appareil.

## Revendications

1. Appareil de mesure électrique (10) disposé dans un boîtier d'appareil (11) présentant, sur une de ses faces (16), des fiches femelles (12) de connexion électrique pouvant recevoir chacune une fiche mâle (13) reliée à un cordon de mesure, l'appareil de mesure (10) comportant une source de tension (34) constituée par au moins un générateur électrochimique et logée dans un compartiment (23,31) qui est fermé par un capot (14) amovible qui présente des trous (39), qui, en position normale, sont alignés avec les fiches femelles (12) de manière à permettre le passage des fiches mâles (13), et du type dans lequel le capot (14) est mobile en translation par rapport au boîtier d'appareil (11) de manière à permettre l'accès à la source de tension (34), caractérisé en ce que le capot est constitué par un boîtier adaptateur (14) amovible monté sur le boîtier de l'appareil (11) et coulissant sur ce dernier selon une direction (A) orthogonale aux axes des fiches femelles (12), les trous (39) du boîtier adaptateur (14) étant aménagés dans une zone de paroi (28) de ce dernier coulissant devant les fiches femelles (12).

2. Appareil de mesure selon la revendication 1, caractérisé en ce que le boîtier adaptateur (14) comporte un compartiment (32) destiné à recevoir un circuit électronique optionnel (36).

3. Appareil de mesure selon la revendication 2, caractérisé en ce que le circuit électronique optionnel (36) comporte un connecteur (46, 47) qui, en position normale, passe à travers une ouverture (48) du boîtier de l'appareil (11).

4. Appareil de mesure selon l'une quelconque des revendications 1 à 3, caractérisé en ce que le compartiment de la source de tension (34) est constitué, au moins partiellement, par une cuvette (23) agencée sur le boîtier de l'appareil (11).

5. Appareil de mesure selon l'une quelconque des revendications 1 à 4, caractérisé en ce que le compartiment de la source de tension (36) est constitué, au moins partiellement, par un logement (31) formé dans le boîtier adaptateur (14).

6. Appareil de mesure selon l'une quelconque des revendications 1 à 5, caractérisé en ce que la zone de paroi (28) du boîtier adaptateur (14) dans laquelle sont aménagés les trous (39) est constituée par une partie saillante (38) d'une paroi du boîtier adaptateur.

7. Appareil de mesure selon la revendication 6, caractérisé en ce que la partie saillante (38) s'engage dans un évidement (41) de la face (16) du boîtier (11) de l'appareil (10) portant les fiches femelles (12).

8. Appareil de mesure selon la revendication 6, caractérisé en ce que la partie saillante (38) est guidée dans la face (16) du boîtier (11) de l'appareil (10) portant les fiches femelles (12).

9. Appareil de mesure selon l'une quelconque des revendications précédentes, caractérisé en ce qu'il est réalisé sous la forme d'une pince ampèremétrique.
